# EUROPEAN PATENT SPECIFICATION

(11) **EP 2 453 479 B1**
(45) Date of publication and mention of the grant of the patent: **16.09.2015**
(21) Application number: 11250888.2
(22) Date of filing: 09.11.2011
(51) Int. Cl.: H01L 27/148

(54) **Back-illuminated CCD imaging device**
Hinten beleuchtete CCD Abbildungsvorrichtung
Capteur d'images CCD éclairé par la face arrière

(30) Priority: 12.11.2010 GB 201019216
(43) Date of publication of application: 16.05.2012
(73) Proprietor: E2V Technologies (UK) Limited, Chelmsford, Essex CM1 2QU (GB)
(72) Inventor: Hadfield, Kevin Anthony Derek, Chelmsford, Essex CM1 4UW (GB)
(74) Representative: Loveless, Ian Mark

(56) References cited:
- EP-A1- 1 146 564
- EP-A1- 1 796 170
- JP-A- 2000 101 061

## Description

This invention relates to CCDs (charge coupled devices).

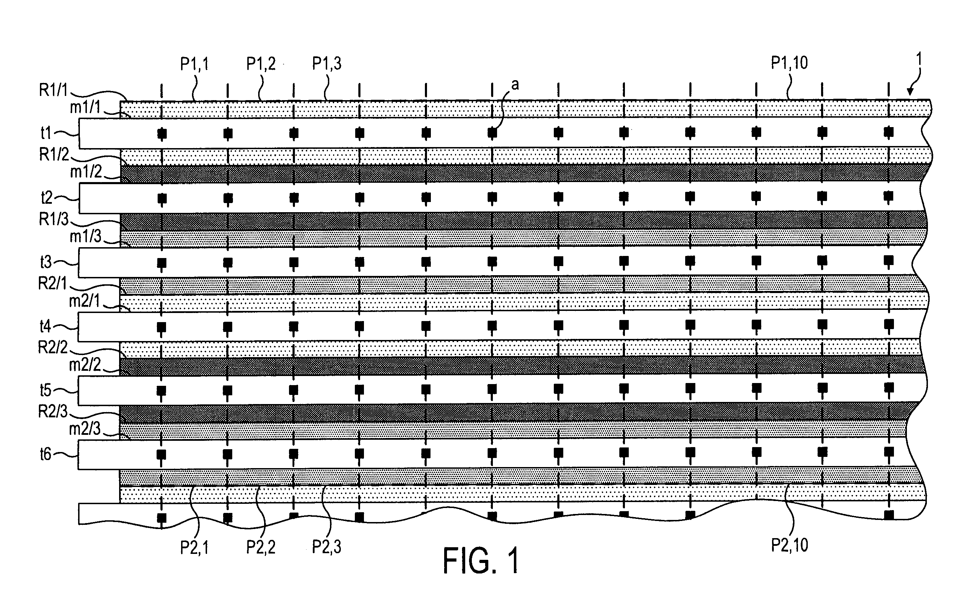

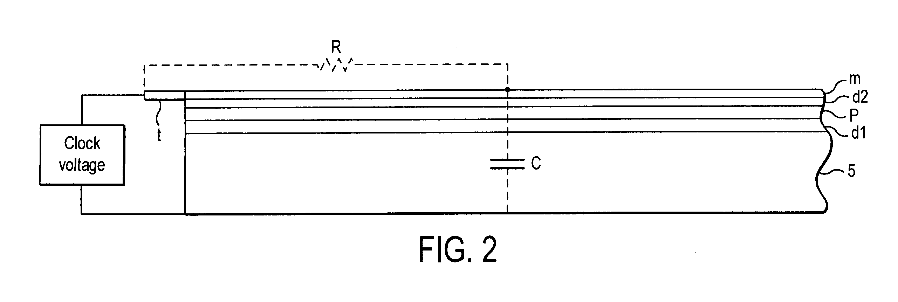

Figure 1 is a plan view of a part of a typical CCD, and Figure 2 a sectional view. The CCD has an imaging area indicated generally by the reference numeral 1 consisting of an array of charge collection sites commonly known as pixels. The part of the array shown extends a little over ten pixels in the row direction and two in the column direction, and the pixels are denoted P1,1, P1,2,P1,3,... P1,10 in the first row and P2,1, P2,2, P2,3,... P2,10 in the second row. The scale in the column direction is enlarged compared to that in the row direction for the purposes of clarity. The full imaging area would typically extend to hundreds of pixels in each direction. In the vertical direction the pixel pitch is defined by horizontal parallel transfer electrodes R1/1, R1/2, R1/3 for the first row and R2/1, R2/2, R2/3 for the second row, to which various voltage phases are applied. The CCD illustrated is a three phase device.

While the image charge pattern is collected, the electrodes are held at fixed potentials. Electrons gather beneath the electrode or electrodes with the highest positive potential. When the exposure period has finished, clocking the electrodes by applying sequential voltages to the phases transfers all the packets of electrons down the device (as seen in the drawings) in the direction of the columns. Because usually all packets in a row move down simultaneously this is known as parallel transfer. The final transfer is into an output register (not shown) which extends in the same direction as the rows, but which has a serial read-out.

In general, modem CCD devices use polysilicon material as the electrodes. Polysilicon has the advantage of allowing light to pass through, of being electrically conductive and of allowing fine features to be etched. These electrodes, denoted as P in Figure 2, lie on a dielectric d1 (silicon dioxide) on a silicon substrate S.

The height of a pixel in the column direction compared to the width of the imaging area is such that the electrodes are typically much longer in the row direction than they are in the column direction, often by a factor of 100 or more. The resistivity of polysilicon means there can be a significant resistance R along each electrode between the sides of the device (where commonly electrical connections are made to the electrodes) and the centre of the device. The electrodes also have capacitance C to the silicon S dependent on the dielectric used resulting in an electrical time constant. The effect of this time constant is to reduce the amplitude of the varying clock voltage at the horizontal centre of the device as the speed of the parallel transfer is increased. The reduced amplitude decreases the size of charge packets that can be moved and may allow them to spill, causing the image to appear smeared down the centre. Some applications require a very fast parallel transfer so this is undesirable.

A known technique to alleviate this problem is to add a horizontal strip of metal m1/1, m1/2, m1/3, m2/1, m2/2, m2/3 over each electrode with contacts 'a' between the electrode and the metal at regular intervals along the length of the strip. There is a penalty that the strips reduce the light reaching the pixels in front-illuminated devices, but this does not apply if the device is back-thinned and illuminated from the backside. In Figure 2, the strips of metal are shown as the layer m over the silicon dioxide layer d2 which grows over the polysilicon electrodes P. Each set of three horizontal strips are connected to respective terminals t1-3, t 4-6 (shown as t in Figure 2), each set of three terminals being supplied with respective phase voltage IΦ1, IΦ2, IΦ3. Because the resistivity of the metal is much lower (typically 500 times lower than the polysilicon), the time constant is significantly reduced and much faster parallel transfers can be achieved.

Unfortunately the nature of silicon wafer processing means that it is difficult to define fine metal features. Therefore so far the technique has been limited to devices with large pixels with relatively wide electrodes in the column direction limiting its application

It has been proposed in a front-illuminated CCD (JP 2000-101061) to provide a set of V-shaped (Figure 10) metal strips in contact with corresponding phase electrodes. The strips are widely spaced to minimise the light-sensitive area they block, which restricts the amount by which the time constant is reduced, and are also driven at the sides and top of the light-sensitive area, which makes it difficult to adapt the design for frame transfer operation.

The invention provides a back-illuminated CCD comprising a two dimensional array of charge collection sites arranged in rows and columns, each row being associated with a plurality of electrodes at the front face extending in the direction of the row and corresponding to respective phase voltages, and a plurality of conducting strips each having repeatedly reversing inclined portions, each portion being in electrical contact with the electrodes of corresponding phase voltage of two or more rows, and each portion being inclined relative to the rows in the opposite direction to that in which the preceding portion is inclined.

Compared to the prior front-illuminated device, the arrangement permits a higher density of conducting tracks and thus faster parallel transfer than hitherto, since the CCD is back-illuminated and the tracks do not obscure the charge collection sites, while allowing the drive connections to be made only at the sides of the array. Compared to the prior back-illuminated device, there is less than one conducting strip per row, and the arrangement is applicable to smaller pixels in the column direction.

Each conducting strip may be zig-zag in shape, or may have curved undulations, for example, it may be sinusoidal.

Advantageously, the inclined portions of each conducting strip are in electrical contact with the respective phase voltage electrodes of no more than ten rows, preferably no more than five rows. Preferably, each conducting strip is in electrical contact with its respective phase voltage electrodes at more than once per fifty charge collection sites in the row direction, preferably more than once per twenty-five charge collection sites.

In a frame transfer CCD, at least some of the conducting strips are preferably in electrical contact with the electrodes of at least one additional row, in order to allow separate operation of the clock voltages for the image and store regions without shorting.

The electrical connection may be achieved by etching away a region of dielectric which will have formed on the electrodes after they have been formed, before the conducting strip is deposited.

The electrodes may be polysilicon electrodes, and the conducting strips may be of aluminium or copper.

Ways of carrying out the invention will now be described in greater detail, by way of example, with reference to the accompanying drawings, in which:
Figure 1 is a fragmentary plan view of part of a known CCD;
Figure 2 is a schematic sectional view of the CCD shown in Figure 1;
Figure 3 is a fragmentary plan view of part of a CCD forming a first embodiment of the invention;
Figure 4 is a schematic plan view of the CCD of Figure 3 showing the clocking voltages;
Figure 5 is a fragmentary plan view of part of a CCD forming a second embodiment of the invention; and
Figure 6 is a schematic plan view of the CCD of Figure 5 showing the clocking voltages.

Like parts have been given like reference numerals throughout all the Figures.

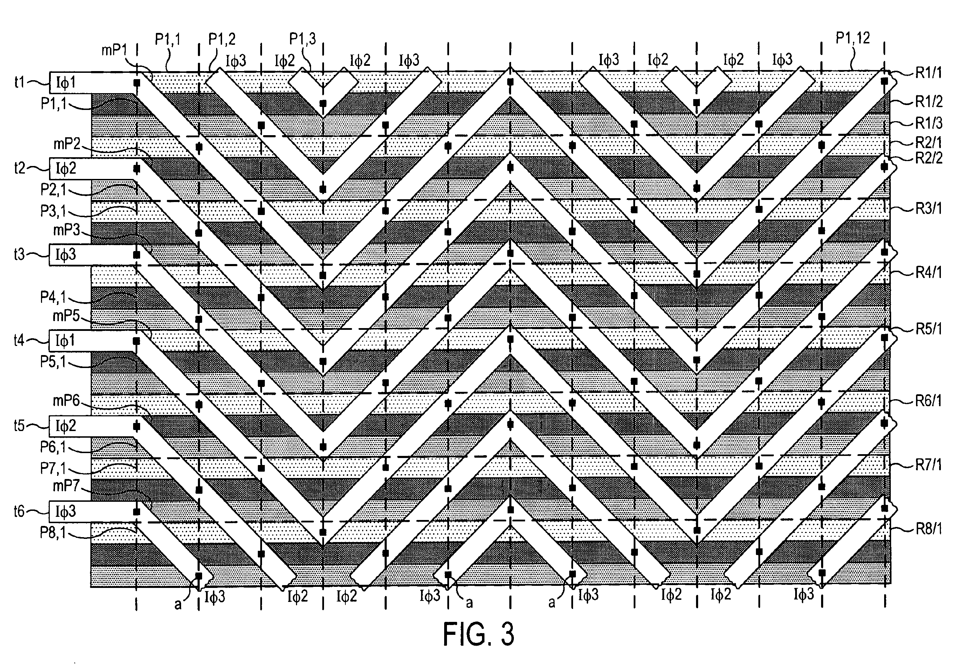

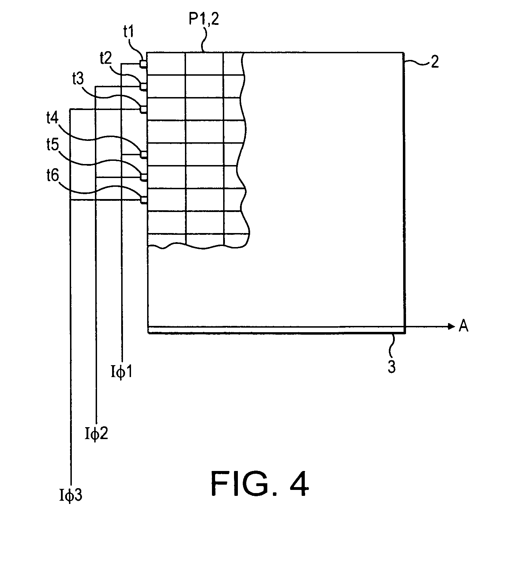

Referring to Figures 2 to 4, a fragmentary region of a back-illuminated full frame CCD according to a first embodiment of the invention is shown. Figure 3 shows a fragmentary region of the array, twelve pixels in the row direction, and eight in the column direction (P1,1, P1,2, P1,3... P1,12 in the row direction and P1,1, P2,1, P3,1, ... P8,1 in the column direction). Figure 4 shows only two of the columns of pixels. In section, the CCD appears the same as the known CCD shown in Figure 2.

In reality, the CCD would have hundreds of pixels in each row and hundreds in each column, a typical array extending 1024 by 1024. The CCD is seen in Figure 3 in top plan, and the illumination strikes the CCD from beneath the plane of the drawing.

Referring to Figure 4, the clocking voltages are applied by lines IΦ1 to IΦ3 to respective terminals t1 to t6. The rows of charge are transferred in parallel fashion to an output register 3, which outputs the charge in serial fashion in the direction of the arrow A.

While the image charge pattern is collected, the electrodes are held at fixed potentials. Electrons gather beneath the electrode or electrodes with the highest positive potential. When the exposure period has finished, clocking the electrodes by applying sequential voltages to the phases transfers all the packets of electrons down the device (as seen in the drawings) in the direction of the columns.

There are three electrodes (Figure 3) corresponding to each row. In the case of the first row, the electrodes are R1/1, R1/2 and R1/3. The electrodes are of polysilicon, and the resistivity of polysilicon means there is a significant resistance R (Figure 2) along each electrode between the terminals t1 to t6, at which the phase voltages IΦ1 to IΦ3 are applied, and the centre of the CCD device. The electrodes also have capacitance C to the silicon S on which the electrodes are mounted dependent on the dielectric (the silicon dioxide layer d1 which forms at the face of the silicon) resulting in an electrical time constant. The effect of this time constant would be to reduce the amplitude of the varying clock voltage at the horizontal centre of the device as the speed of the parallel transfer is increased.

Zig-zag strips of metal mP1, mP2, mP3, mP5, mP6, mP7, etc are provided to reduce the time constant of voltage variation at the centre of the electrodes, which can be closely spaced and driven only at the sides of the array.

The first row has a terminal t1 connected to the first voltage phase IΦ1. The second row has a terminal t2 connected to the second voltage phase IΦ2. The third row has a terminal t3 connected to the third voltage phase IΦ3. The fourth row does not have a terminal, and the next terminal t4 for the first voltage phase IΦ 1 is provided on the next row in order to avoid the need to have the terminal for the IΦ1 phase immediately adjacent to the terminal for the IΦ3 phase. All terminals IΦ1 etc are commonly driven by the respective voltage phase as shown in Figure 4.

In order that each electrode of each row is supplied with the required phase voltage, each strip mP1, mP2, mP3, mP5, mP6, mP7 connects to a respective terminal t1 to t6 and makes electrical connection with the electrodes which are driven at corresponding phases in four rows. For example, the conducting strip mP1 connected to terminal t1 driven by phase IΦ1 makes electrical contact with the phase IΦ1 electrodes in the four rows, R1/1, R2/1, R3/1 and R4/1. Successive portions of the strips of metal, for example, of mP1, are inclined to the rows in repeatedly reversing directions and make multiple connections to each polysilicon electrode of the respective voltage phase along its length.

The electrical connections of the strips mPn to the polysilicon electrodes Rn/n is achieved by etching through regions of the insulating silicon diode layer d2 which forms on the polysilicon electrodes Rn/n (Figure 2). A thin layer of metal is then deposited all over the wafer, and etched away where unwanted leaving the continuous zig-zag pattern of the conducting strips mPn. Shallow square depressions in the strips are visible over the etched away regions, indicating the contact regions from the metal tracks to the electrodes below, typical ones of which are indicated by the reference 'a'. Each metal conductor makes contact with the associated polysilicon electrodes at frequent intervals across the CCD device, typically hundreds of times.

The embodiment of Figures 3 and 4 uses three phase image clocks, but the technique is also applicable to CCDs with other numbers of phases, such as two phase and four phase. Typically the vertical pitch of the metal tracks will be a multiple of the pitch of the electrodes and the angles of the zigzag to the horizontal optimised according the sensor requirements such as horizontal and vertical pixel size (pixels are not necessarily square) and the number of parallel transfer electrodes defining each pixel.

Since the metal tracks may reflect light that passes all the way through the silicon (mainly of concern for red or infra-red light that penetrates silicon more deeply) increasing the likelihood of capture of photons, the width and angle of the tracks may be chosen to help equalise the amount of metal over each pixel and hence reduce the variation in sensitivity from pixel to pixel.

It is in general desirable for the zigzag metal track not to extend over more vertical electrodes than necessary since the metal track will be longer, increasing its resistance, and there may be fewer contacts from the metal track to the corresponding polysilicon electrodes.

A typical CCD with traditional straight metal tracks of the kind shown in Figure 1 having a maximum parallel transfer speed of at least 10 MHz (compared to a parallel transfer speed of 2 MHz without metal tracks) can be made with a minimum pitch of pixel in the column direction of 30 micrometres. A CCD with zig-zag metal tracks according to the invention can maintain the same speed of transfer with a much smaller pixel pitch, for example, 12 micrometres. The zig-zag metal tracks could have a width of as little as 8 microns, spaced by as little as 6 microns.

Variations may of course be made to the described embodiment without departing from the scope of the invention. Thus, the zig-zag could include flat sections at the tops and bottoms of the zig-zag, the angles of the zigzag sections could vary along the length of the rows, or the strips could undulate in a continuous fashion, for example, sinusoid-shaped metal strips could be used. The terminals for the phase voltages could be provided at every fourth row, instead of every fifth row as illustrated. Adjacent terminal connections could be avoided by splitting them between opposite sides of the array. Equally, terminals could be provided at every sixth row, or at a greater interval, by arranging that the conducting strips extend over and make electrical connection with a greater number of rows. Equally, more than one strip could be provided per each row, for example, two strips could be provided per three electrodes, as long as there are less metal tracks than electrodes. Materials other than aluminium could be used for the conducting strips, for example, copper. Also, there is no need for the electrodes to be of polysilicon, they could be of other materials. There is also no requirement for the CCD to have a silicon substrate.

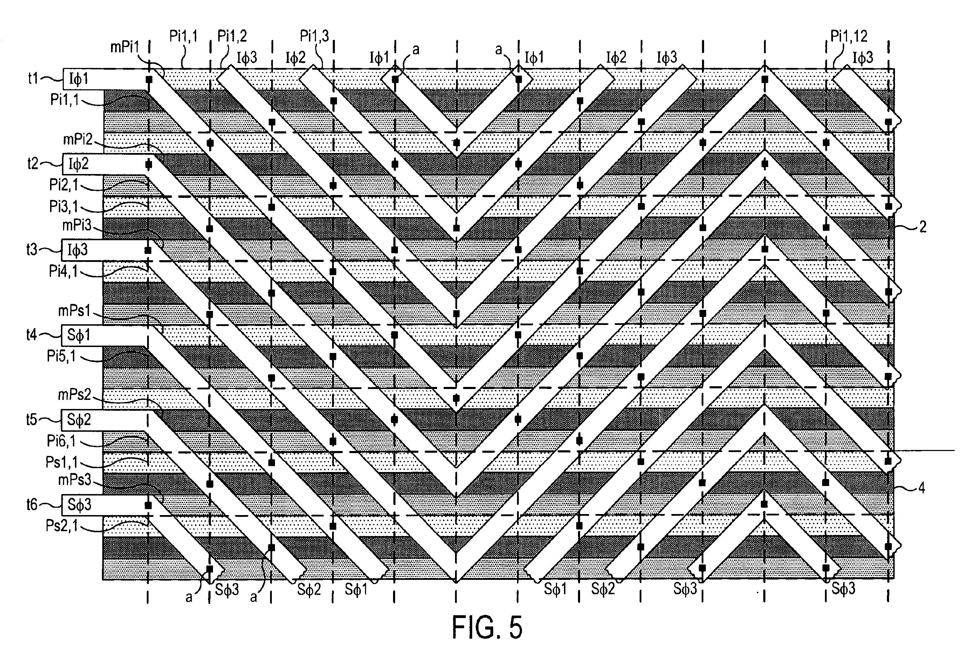

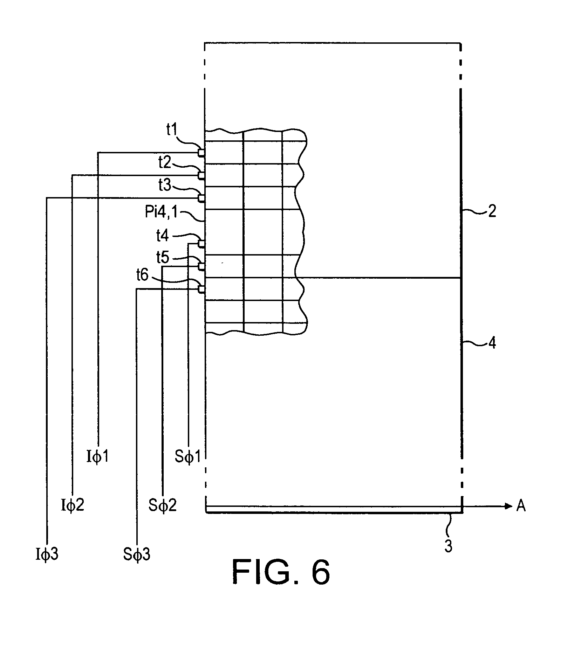

Referring to Figures 2, 5 and 6, a frame transfer CCD is shown according to a second embodiment of the invention. Figure 5 shows rows of pixels on each side of the transition between image region and store region, namely, Pi1,1, Pi2,1, Pi3,1, Pi4,1, Pi5,1 and Pi6,1 in the image region 2 and Ps1,1, Ps2,1 in the store region 4. Figure 5 shows twelve columns (up to Pi1,12) while Figure 6 shows just two. In section, the CCD is the same as the prior art CCD of Figure 2. In commercial devices, there would be hundreds of rows in the image region, for example, 1024 rows by 1024 columns in the image area, and typically slightly more rows in the store region. Each bottom row of the store region 2 is transferred to an output register 3, which has a serial output in the direction of the arrow A.

In such CCDs, the image region and store region of the CCD are operated by different clocking waveforms, the image region 2 by three phase image clocks (IΦ1, IΦ2 and IΦ3) and the store region 4 is clocked by three phase store region clocks (SΦ1, SΦ2 and SΦ3). Typically, the image and store region phase clocks would be such as to shift the charge pattern in the image region rapidly into the store region, to avoid frame transfer smear. The readout from the store region will typically take much longer, since this can take place over one integration period in which a frame is exposed in the image region. A typical shift from the image region to the store region would take place in approximately 0.1ms, while readout from the store region would typically take 20ms.

There will be occasions when the store clocks and the image clocks have different voltages applied to them, such as during an integration period where the image clocks will be held at fixed potentials, while the store clocks will be transporting the charges to the output register 3, from each row to the adjacent one.

In the second embodiment of the invention, the zigzag pattern extends vertically over a greater number of rows than in the first embodiment (six rows instead of four rows). The metal strips are mPi1, mPi2, mPi3 for the image region and mPs1, mPs2, mPs3 for the store region. Each strip connects to the relevant phase voltages at terminals t1 to t6. It will be noted that the conducting strips which extend over the last two rows of the image region 2 and the first row of the store region 4 are connected to both image and store clocks. However, the conducting strips mPs1 and mPs2 connected to the store clocks do not make electrical connection to the electrodes of the last two rows of the image region 2. This avoids a short between corresponding image and store clocks. During frame transfer, both image and store clocks operate in synchronism. During integration, the store clocks operate while the image clocks do not.

Similar constraints will apply to CCDs with other numbers of phases in the image and store regions.

In the second embodiment of the invention, the image region and the store region are adjacent to each other. However, there may be a pipelined connection between them. Thus, a CCD could be constructed with one image section with two (or more) store sections beneath, each section with its own set of clocks. The advantage is that two images could be captured quickly, the first moved down to the lower of the two store sections and the second moved down to the upper of the two store sections. The two images, captured close together in time, can then be read out at normal speed. There would be multiple boundaries where the clocks must change over to a different set (e.g. image to store 1 and also store 1 to store 2 in this example).

Further, the invention is not only applicable to full frame CCDs, as in the first embodiment, or frame transfer CCDs, as in the second embodiment, it also applies to interline transfer CCDs and TDI CCDs, or other CCDs employing parallel transfer. While the CCDs described above have all had straight electrodes, the invention is also applicable to CCDs with curved electrodes.

## Claims

1. A back-illuminated CCD comprising a two dimensional array of charge collection sites arranged in rows and columns, each row being associated with a plurality of electrodes (Rn/n) at the front face extending in the direction of the row and corresponding to respective phase voltages (IΦn), and **characterised by** a plurality of conducting strips (nPn) each having repeatedly reversing inclined portions, each portion being in electrical contact with the electrodes of corresponding phase voltage of two or more rows, and each portion being inclined relative to the rows in the opposite direction to that in which the preceding portion is inclined.

2. A CCD as claimed in claim 1, in which each conducting strip is zig-zag in shape.

3. A CCD as claimed in claim 1, in which each conducting strip has curved undulations.

4. A CCD as claimed in any one of claims 1 to 3, in which each conducting strip is associated with a terminal for supplying a respective voltage phase at a side of the array.

5. A CCD as claimed in any one of claims 1 to 4, in which each conducting strip is in electrical contact with its respective phase voltage electrodes at more than once per twenty-five charge collection sites in the row direction.

6. A CCD as claimed in any one of claims 1 to 5, in which the inclined portions of each conducting strip are in electrical contact with the respective phase voltage electrodes of no more than ten rows.

7. A CCD as claimed in any one of claims 1 to 6, in which the conducting strips are in at least two sets associated with different clocking voltages, the strips of both sets extending over at least one row but the strips of one set only making electrical connection with the electrodes of that row.

8. A CCD as claimed in claim 7, the different clocking voltages are for an image region and for a store region of a frame transfer CCD.

## Patentansprüche

1. Rückseitig beleuchtetes CCD, das eine zweidimensionale Anordnung von Ladungssammelstellen umfasst, die in Reihen und Spalten angeordnet sind, wobei jede Reihe mit mehreren Elektroden (Rn/n) an der Frontfläche assoziiert ist, die in der Richtung der Reihe verlaufen und jeweiligen Phasenspannungen (Iφn) entsprechen, und **gekennzeichnet durch** mehrere leitende Streifen (nPn) jeweils mit Abschnitten mit wiederholt umgekehrter Neigung, wobei jeder Abschnitt mit den Elektroden einer entsprechenden Phasenspannung von zwei oder mehr Reihen in elektrischem Kontakt ist und wobei jeder Abschnitt relativ zu den Reihen in der entgegengesetzten Richtung zu der geneigt ist, in der der vorhergehende Abschnitt geneigt ist.

2. CCD nach Anspruch 1, wobei jeder leitende Streifen zickzack-förmig ist.

3. CCD nach Anspruch 1, wobei jeder leitende Streifen kurvenförmige Wellen hat.

4. CCD nach einem der Ansprüche 1 bis 3, wobei jeder leitende Streifen mit einem Anschluss zum Anlegen einer jeweiligen Spannungsphase an eine Seite der Anordnung assoziiert ist.

5. CCD nach einem der Ansprüche 1 bis 4, wobei jeder leitende Streifen mehr als einmal pro fünfundzwanzig Ladungssammelstellen in der Reihenrichtung mit seinen jeweiligen Phasenspannungselektroden in elektrischem Kontakt ist.

6. CCD nach einem der Ansprüche 1 bis 5, wobei die geneigten Abschnitte jedes leitenden Streifens mit den jeweiligen Phasenspannungselektroden von mehr als zehn Reihen in elektrischem Kontakt sind.

7. CCD nach einem der Ansprüche 1 bis 6, wobei die leitenden Streifen in wenigstens zwei mit unterschiedlichen Taktspannungen assoziierten Sätzen vorliegen, wobei die Streifen beider Sätze über wenigstens eine Reihe verlaufen, aber die Streifen von einem Satz nur mit den Elektrdoen dieser Reihe in elektrische Verbindung kommen.

8. CCD nach Anspruch 7, wobei die unterschiedlichen Taktspannungen für eine Bildregion und für eine Speicherregion eines Frame-Transfer-CCD sind.

## Revendications

1. CCD éclairé par l'arrière comprenant une matrice bidimensionnelle de sites de collection de charges arrangés en rangées et en colonnes, chaque rangée étant associée à une pluralité d'électrodes (Rn/n) à la face avant s'étendant dans la direction de la rangée et correspondant à des tensions de phase respectives (IΦn), et **caractérisé par** une pluralité de bandes conductrices (nPn) ayant chacune des parties inclinées s'inversant répétitivement, chaque partie étant en contact électrique avec les électrodes de la tension de phase correspondante de deux rangées ou plus, et chaque partie étant inclinée par rapport aux rangées dans la direction opposée à celle dans laquelle la partie précédente est inclinée.

2. CCD selon la revendication 1, dans lequel chaque bande conductrice est en forme de zigzag.

3. CCD selon la revendication 1, dans lequel chaque bande conductrice a des ondulations courbées.

4. CCD selon l'une quelconque des revendications 1 à 3, dans lequel chaque bande conductrice est associée à une borne pour fournir une tension de phase respective à un côté de la matrice.

5. CCD selon l'une quelconque des revendications 1 à 4, dans lequel chaque bande conductrice est en contact électrique avec ses électrodes de tension de phase respective à plus d'un site tous les vingt-cinq sites de collection de charges dans la direction de la rangée.

6. CCD selon l'une quelconque des revendications 1 à 5, dans lequel les parties inclinées de chaque bande conductrice sont en contact électrique avec les électrodes de tension de phase respective de pas plus de dix rangées.

7. CCD selon l'une quelconque des revendications 1 à 6, dans lequel les bandes conductrices sont dans au moins deux ensembles associés à des tensions d'horloge différentes, les bandes des deux ensembles s'étendant sur au moins une rangée mais les bandes d'un ensemble ne faisant une connexion électrique qu'avec les électrodes de cette rangée.

8. CCD selon la revendication 7, les différentes tensions d'horloge sont pour une région d'image et pour une région de stockage d'un CCD à transfert de trame.
